# EUROPEAN PATENT APPLICATION

(11) **EP 4 583 219 A2**
(43) Date of publication of application: **09.07.2025**
(21) Application number: 24219803.4
(22) Date of filing: 13.12.2024
(51) Int. Cl.: H01M 10/04, H01M 10/42, H01M 10/48, H01M 50/209, H01M 50/284, H01M 50/569

(54) **RECHARGEABLE BATTERY MODULE**

(30) Priority: 05.01.2024 KR 20240002488
(71) Applicant: SAMSUNG SDI CO., LTD., Yongin-si, Gyeonggi-do 17084 (KR)
(72) Inventor: Ahn, Jaepil, 17084 Yongin-si, Gyeonggi-do (KR); Yun, Chuljung, 17084 Yongin-si, Gyeonggi-do (KR)
(74) Representative: Gulde & Partner

(57) **Abstract**

A rechargeable battery module includes: a busbar holder (20) configured to cover a plurality of battery cells (10); a flexible printed circuit, FPC, (30) configured to transmit a signal corresponding to a detected temperature of at least one of the battery cells (10) from a temperature sensor (31) mounted on the busbar holder (20); a temperature sensing tab (40) including a sensor connection portion (41) at a first side that is connected to the temperature sensor (31) and a cell contact portion (42) at a second side that is coupled to the busbar holder (20) and in contact with the one of the battery cells (10); and an elastic member (50) coupled to the cell contact portion (42) and configured to elastically pressurize the cell contact portion (42) onto the one of the battery cells (10).

## Description

### BACKGROUND

### 1. Field

The present invention relates to a rechargeable battery module.

### 2. Description of the Related Art

A rechargeable battery is a battery that is designed to be repeatedly charged and discharged, different from a primary battery. A small-capacity rechargeable battery may be used in a portable, small electronic device, such as a mobile phone, a laptop computer, and a camcorder.

A large-capacity and high-density rechargeable battery may be used for a power source or energy storage for driving a motor of a hybrid vehicle and an electric vehicle. The rechargeable battery may be used as a rechargeable battery module including a plurality of battery cells connected together in series and/or in parallel to be able to, as an example, drive a motor of a hybrid vehicle, which requires a relatively high energy density.

Generally, the rechargeable battery module detects the temperature of a cell with a temperature sensor and transmits the detection signal through a flexible printed circuit (FPC). The temperature sensor mounted on the FPC is soldered to a separate nickel tab (Ni-Tab), and the nickel tab is laser welded to the battery cell so that the temperature sensor can detect the temperature of the battery cell through the nickel tab.

### SUMMARY

A rechargeable battery module comprises a temperature sensor that is connected between a flexible printed circuit (FPC) and a battery cell. The invention provides a rechargeable battery module capable of reducing or eliminating defects that may be caused by welding because welding is not used to connect a tab to which a temperature sensor mounted on a flexible printed circuit (FPC) to a battery cell. The invention also provides a rechargeable battery module capable of reducing or eliminating certain costs, such as a process cost and quality management cost, because welding is not used.

A rechargeable battery module, according to the present invention, includes a busbar holder configured to cover a plurality of battery cells; a flexible printed circuit (FPC) configured to transmit a signal corresponding to a detected temperature of at least one of the battery cells from a temperature sensor mounted on the busbar holder; a temperature sensing tab including a sensor connection portion at a first side that is connected to the temperature sensor and a cell contact portion at a second side that is coupled to the busbar holder and in contact with the one of the battery cells; and an elastic member coupled to the cell contact portion and configured to elastically pressurize or press the cell contact portion onto the one of the battery cells. The elastic member may be essentially H-shaped.

The cell contact portion may include: a contact plate portion in contact with the one of the battery cells; a first catching portion in the contact plate portion at a side away from the sensor connection portion and on the busbar holder; and a second catching portion spaced apart from the first catching portion and in the contact plate portion nearer to the sensor connection portion than the first catching portion is and coupled under the busbar holder. The first catching portion may be an appendix of the contact plate portion and / or may be formed as a protrusion or tongue. The second catching portion may be an appendix of the contact plate portion and / or may be formed as a protrusion or tongue.

The elastic member may include: a first elastic portion coupled at a first through hole in the first catching portion and configured to apply an elastic force to the first catching portion; and a second elastic portion coupled at a second through hole in the second catching portion and configured to apply an elastic force to the second catching portion. The first elastic portion may apply the elastic force in response to an elastic deformation of the first elastic portion. The second elastic portion may apply the elastic force in response to an elastic deformation of the second elastic portion.

The elastic member may further include a connection portion interconnecting the first elastic portion and the second elastic portion in a crossing direction. The first and second elastic portions may form the sides of the H-shape of the elastic member and the connection portion may for the middle bar of the H-shape of the elastic member.

The busbar holder may include: a seating groove having an open top corresponding to the first catching portion; and a hook having an open bottom corresponding to the second catching portion.

The first catching portion may extend in a horizontal direction in the seating groove, and the second catching portion may extend in an inclined direction and may be restrained under the hook.

The second catching portion may be configured to: in a first state, form a first angle by being bent from the contact plate portion; and in a second state when caught by the hook, form a second angle that is greater than the first angle.

A second elastic portion may have a curved shape convex toward the contact plate portion in a free state, that may be a free state of the second elastic portion, and may be configured to provide an elastic force toward the contact plate portion in a state in which it is coupled to the second catching portion restrained by the hook. The second elastic portion may apply the elastic force in response to an elastic deformation of the second elastic portion out of its free state and into the state in which it is coupled to the second catching portion restrained by the hook.

The elastic force provided to the contact plate portion through the second catching portion by the second elastic portion may be highest at a center of the contact plate portion and may decrease toward both ends.

In a free state, the first catching portion may be configured to form an angle that is greater than the first angle by being bent from the contact plate portion. The free state may be a free state of the first catching portion.

In a free state, a first elastic portion of the elastic member may have a curved shape convex toward the contact plate portion and may be configured to provide an elastic force toward the contact plate portion in a state in which it is coupled to the first catching portion in the seating groove. The free state may be a free state of the first elastic portion. The first elastic portion may apply the elastic force in response to an elastic deformation of the first elastic portion out of its free state and into the state in which it is coupled to the first catching portion in the seating groove.

The elastic force provided to the contact plate portion through the first catching portion by the first elastic portion may be highest at a center of the contact plate portion and may decrease toward both ends.

The cell contact portion may include: a contact plate portion in contact with the one of the battery cells; a pair of first catching portions respectively extending from opposite sides of the contact plate portion in a width direction at an area of the contact plate portion away from the sensor connection portion, the first catching portions being on the busbar holder; and a pair of second catching portions respectively extending from the opposite sides of the contact plate portion in the width direction at another area of the contact plate portion nearer to the sensor connection portion, the second catching portions being coupled under the busbar holder. The elastic member may include: a first elastic portion coupled to each of first through holes respectively in the pair of first catching portions and configured to apply an elastic force to the first catching portion; and a second elastic portion coupled to each of second through holes respectively in the pair of second catching portions and configured to apply an elastic force to the second catching portion.

At the same height on the contact plate portion: the pair of first catching portions may form a first gap; and the pair of second catching portions may form a second gap that is greater than the first gap.

According to an embodiment, because a temperature sensing tab may be formed as a sensor connection portion, and a cell contact portion and a temperature sensor of the flexible printed circuit (FPC) is connected to the sensor connection portion, a temperature sensor may be connected between a flexible printed circuit (FPC) and a battery cell.

In addition, according to an embodiment, welding may not be used and, instead, a cell contact portion in contact with the battery cell and elastically pressurizing the cell contact portion by an elastic member may be utilized to prevent defects that may be caused by welding. According to an embodiment, because welding is not used to connect the temperature sensor to the battery cell, costs, such as the process cost and quality management cost, may be eliminated.

In its free state the respective portion may be free from external forces seeking to deform the respective portion.

### BRIEF DESCRIPTION OF THE DRAWINGS

FIG. 1 is a partial perspective view of a rechargeable battery module according to an embodiment.
FIG. 2 is a partial perspective view showing a flexible printed circuit, a temperature sensing tab, and an elastic member in a rechargeable battery module according to an embodiment.
FIG. 3 is a top plan view of the flexible printed circuit, the temperature sensing tab, and the elastic member shown in FIG. 2.
FIG. 4 is a cross-sectional view taken along the line IV-IV in FIG. 3.
FIG. 5 is a top plan view of the flexible printed circuit, the temperature sensing tab, the elastic member, and a busbar holder according to an embodiment.
FIG. 6 is a cross-sectional view taken along the line VI-VI in FIG. 5.
FIG. 7 is a perspective view of the temperature sensing tab shown in FIG. 3.
FIG. 8 is a cross-sectional view showing before and after states of a first coupling portion of an elastic member being coupled to a first catching portion of a temperature sensing tab.
FIG. 9 is a cross-sectional view showing before and after states of a second coupling portion of an elastic member being coupled to a first catching portion of a temperature sensing tab.

### DETAILED DESCRIPTION

The present invention will be described more fully hereinafter with reference to the accompanying drawings, in which embodiments of the present invention are shown. As those skilled in the art would realize, the described embodiments may be modified in various different ways. The drawings and description are to be regarded as illustrative in nature.

It will be understood that when an element or layer is referred to as being "on," "connected to," or "coupled to" another element or layer, it may be directly on, connected, or coupled to the other element or layer or one or more intervening elements or layers may also be present. When an element or layer is referred to as being "directly on," "directly connected to," or "directly coupled to" another element or layer, there are no intervening elements or layers present. For example, when a first element is described as being "coupled" or "connected" to a second element, the first element may be directly coupled or connected to the second element or the first element may be indirectly coupled or connected to the second element via one or more intervening elements.

In the figures, dimensions of the various elements, layers, etc. may be exaggerated for clarity of illustration. The same reference numerals designate the same elements. As used herein, the term "and/or" includes any and all combinations of one or more of the associated listed items. Further, the use of "may" when describing embodiments of the present disclosure relates to "one or more embodiments of the present disclosure." Expressions, such as "at least one of" and "any one of," when preceding a list of elements, modify the entire list of elements and do not modify the individual elements of the list. For example, the expression "at least one of a, b, or c" indicates only a, only b, only c, both a and b, both a and c, both b and c, all of a, b, and c, or variations thereof. As used herein, the terms "use," "using," and "used" may be considered synonymous with the terms "utilize," "utilizing," and "utilized," respectively. As used herein, the terms "substantially," "about," and similar terms are used as terms of approximation and not as terms of degree, and are intended to account for the inherent variations in measured or calculated values that would be recognized by those of ordinary skill in the art.

It will be understood that, although the terms first, second, third, etc. may be used herein to describe various elements, components, regions, layers, and/or sections, these elements, components, regions, layers, and/or sections should not be limited by these terms. These terms are used to distinguish one element, component, region, layer, or section from another element, component, region, layer, or section. Thus, a first element, component, region, layer, or section discussed below could be termed a second element, component, region, layer, or section without departing from the teachings of example embodiments.

Spatially relative terms, such as "beneath," "below," "lower," "above," "upper," and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" or "over" the other elements or features. Thus, the term "below" may encompass both an orientation of above and below. The device may be otherwise oriented (rotated 90 degrees or at other orientations), and the spatially relative descriptors used herein should be interpreted accordingly.

The terminology used herein is for the purpose of describing embodiments of the present invention. As used herein, the singular forms "a" and "an" are intended to include the plural forms as well, unless the context clearly indicates otherwise. It will be further understood that the terms "includes," "including," "comprises," and/or "comprising," when used in this specification, specify the presence of stated features, integers, steps, operations, elements, and/or components but do not preclude the presence or addition of one or more other features, integers, steps, operations, elements, components, and/or groups thereof.

In a rechargeable battery module, the position of the temperature sensing tab needs to be fixed to weld it to a battery cell. Accordingly, to fix the temperature sensing tab to a busbar holder, the temperature sensing tab may have a locking structure. However, during assembling, a defect may occur in that the temperature sensing tab may be deformed or the temperature sensing tab may not be engaged with the busbar holder.

In addition, even if the temperature sensing tab is engaged with the busbar holder, welding defects may occur due to lifting of the temperature sensing tab from the battery cell. In addition, when welding the battery cell and the temperature sensing tab together, defects may occur depending on the welding condition, or foreign particles at the welding point may be present or may be generated, causing a defect.

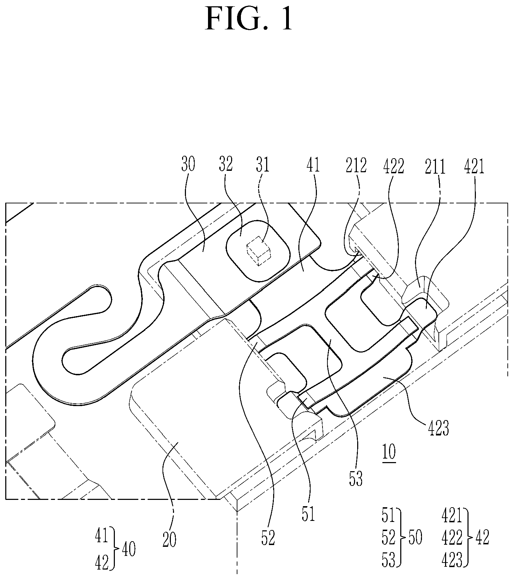

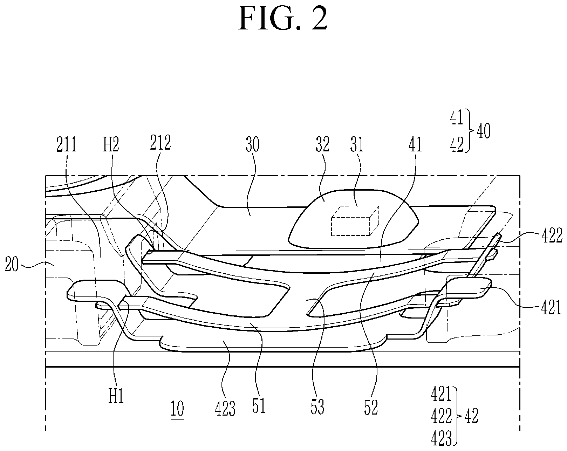

FIG. 1 is a partial perspective view of a rechargeable battery module according to an embodiment. FIG. 2 is a partial perspective view primarily showing a flexible printed circuit, a temperature sensing tab, and an elastic member in the rechargeable battery module shown in FIG. 1. Referring to FIG. 1 and FIG. 2, a rechargeable battery module, according to an embodiment, may include a busbar holder 20 configured to cover a plurality of battery cells 10, a flexible printed circuit (FPC) 30, a temperature sensing tab 40, and an elastic member 50.

The busbar holder 20 may be formed of an electrical insulation material (e.g., an electrically insulative material) and may be configured to cover the plurality of battery cells 10 to hold (or fix) the position of the busbars that electrically connect the battery cells 10 to each other. The flexible printed circuit (FPC) 30 may be configured to detect the temperature of the busbars and the battery cell 10 and to transmit the detected temperature, e.g. to a battery management system (BMS). As an example, the flexible printed circuit 30 is configured to mount (or to receive or accommodate) a temperature sensor 31, and the temperature sensor 31 may be covered by an insulation material 32 to be electrically insulated. The flexible printed circuit 30 may be provided on a lower surface or an upper surface of the busbar holder 20. In the illustrated embodiment, the flexible printed circuit 30 shown being on the upper surface of the busbar holder 20 as an example.

The temperature sensing tab 40 may include a sensor connection portion 41 and a cell contact portion 42 that are integrally formed. The temperature sensor 31 may be connected to the sensor connection portion 41. For example, because the temperature sensor 31 is electrically connected to the flexible printed circuit 30 and is mechanically in surface contact with the sensor connection portion 41, it may effectively detect a temperature (e.g., heat) of the battery cell 10 through the sensor connection portion 41 and may transmit it through the flexible printed circuit 30.

The cell contact portion 42 may be coupled to the busbar holder 20 to be in contact with the battery cell 10. Accordingly, when the busbar holder 20 covers the battery cells 10, the cell contact portion 42 may be in stable contact with the battery cell 10 and configured to detect the temperature of the battery cell 10. In this state, the gap between the cell contact portion 42 and the battery cell 10 is zero (0).

To further secure the temperature sensing tab 40 to the battery cell 10, the elastic member 50 may be coupled to the cell contact portion 42 and may elastically pressurize or press the cell contact portion 42. For example, because the elastic member 50 is coupled to the cell contact portion 42, which is coupled to the busbar holder 20, and applies an elastic force to the cell contact portion 42 to resist against the force of the cell contact portion 42 floating from (or moving away from) the battery cell 10, the cell contact portion 42 may elastically contact the battery cell 10. The gap between the cell contact portion 42 and the battery cell 10 may stably maintain at zero (0).

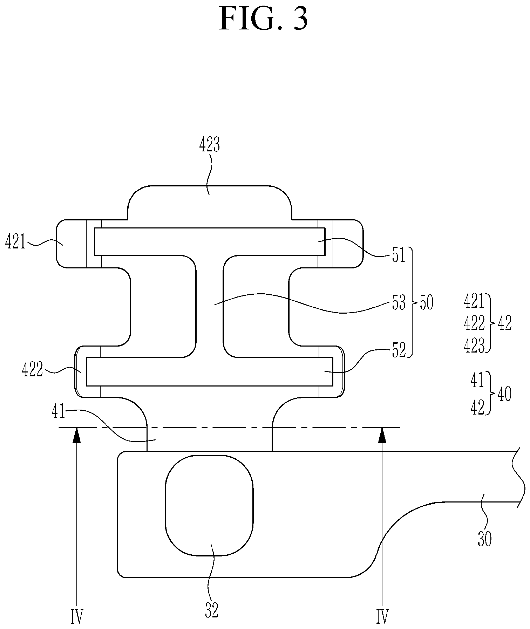

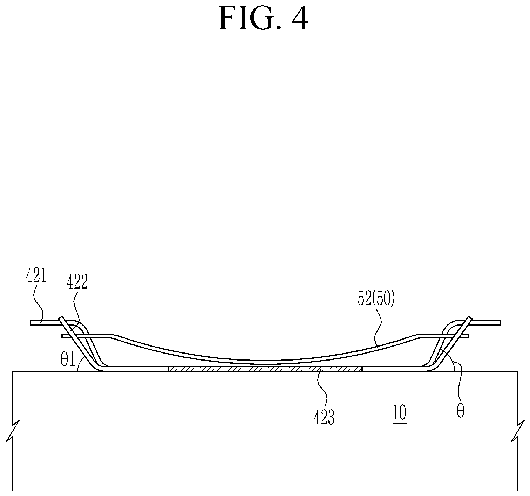

FIG. 3 is a top plan view of the flexible printed circuit, the temperature sensing tab, and the elastic member shown in FIG. 2. FIG. 4 is a cross-sectional view taken along the line IV-IV in FIG. 3. Referring to FIG. 1 to FIG. 4, the cell contact portion 42 includes a contact plate portion 423, a first catching portion 421, and a second catching portion 422.

The contact plate portion 423 may be in direct contact with the battery cell 10 to receive and transfer the heat of the battery cell 10. The contact plate portion 423 may be formed to be integrally connected to the sensor connection portion 41. Accordingly, the heat of the battery cell 10 detected at the contact plate portion 423 may be transferred to the temperature sensor 31, which is in contact with the sensor connection portion 41, through the sensor connection portion 41.

The first catching portion 421 may be located in (e.g., may extend or protrude from) the contact plate portion 423 away from (e.g., opposite to) the sensor connection portion 41 and may be disposed on the busbar holder 20. The second catching portion 422 may be spaced apart from the first catching portion 421 and located in the contact plate portion 423 near the sensor connection portion 41 and coupled under the busbar holder 20. For example, the contact plate portion 423 may be engaged with the busbar holder 20 through the first and second catching portions 421 and 422.

The contact plate portion 423 of the cell contact portion 42 may be in contact with the battery cell 10. In this state, the first catching portion 421 may be located in the contact plate portion 423 away from the sensor connection portion 41 and disposed on the busbar holder 20, and the first catching portion 421 may be disposed on both sides of the contact plate portion 423 in a width direction as a pair.

In addition, the second catching portion 422 may be spaced apart from the first catching portion 421, located in the contact plate portion 423 near the sensor connection portion 41, and coupled under the busbar holder 20, and the second catching portion 422 may be disposed on both sides of the contact plate portion 423 in the width direction as a pair.

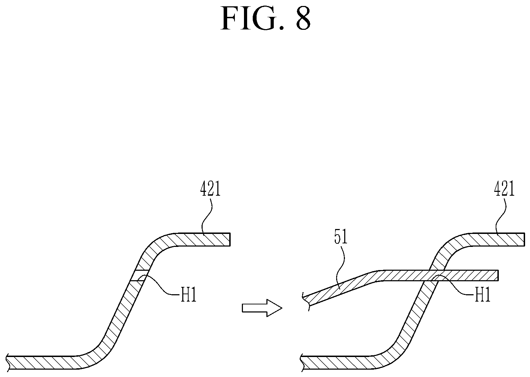

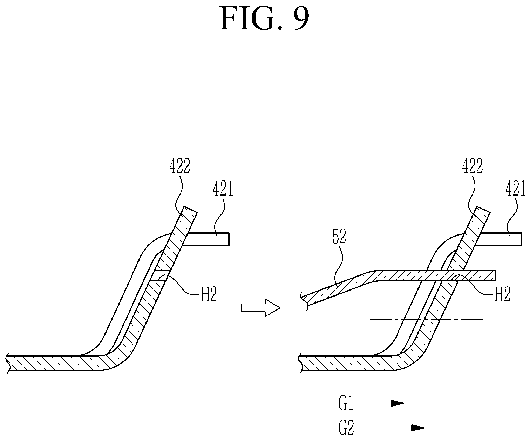

FIG. 8 is a cross-sectional view showing before and after states of a first coupling portion of an elastic member that is coupled to a first catching portion (e.g., in a generally horizontal state) of the temperature sensing tab. FIG. 9 is a cross-sectional view showing before and after states of a second coupling portion of an elastic member that is coupled to a first catching portion (e.g., in a generally inclined state) of the temperature sensing tab.

Referring to FIGS. 1-4, FIG. 8, and FIG. 9, the elastic member 50 includes a first elastic portion 51, a second elastic portion 52, and a connection portion 53. The first elastic portion 51 may be coupled to the first catching portion 421 at a first through hole H1 therein and may be configured to apply an elastic force to the first catching portion 421. The second elastic portion 52 may be coupled to the second catching portion 422 at a second through hole H2 therein and may be configured to apply an elastic force to the second catching portion 422. The connection portion 53 may interconnect the first elastic portion 51 and the second elastic portion 52 in a crossing direction and may ensure uniformness of the elastic force applied by the first elastic portion 51 and the second elastic portion 52.

The first elastic portion 51 of the elastic member 50 may be coupled to each of the first through holes H1 in the pair of first catching portions 421 and configured to apply an elastic force to the first catching portion 421. In addition, the second elastic portion 52 may be coupled to each of the second through holes H2 in the pair of second catching portions 422 and configured to apply an elastic force to the second catching portion 422.

Referring to FIG. 9, the pair of first catching portions 421 may form a first gap G1 at the same height on the contact plate portion 423, and the pair of second catching portions 422 may form a second gap G2 that is greater than the first gap G1.

The pair of first catching portions 421 is caught by (e.g., is restrained by) the upper surface of the busbar holder 20 by the relatively short first gap G1, and the pair of second catching portions 422 is caught by (e.g., is restrained by) a lower surface of the busbar holder 20 by the relatively long second gap G2. Accordingly, the contact plate portion 423 may maintain stable contact structure with respect to the battery cell 10.

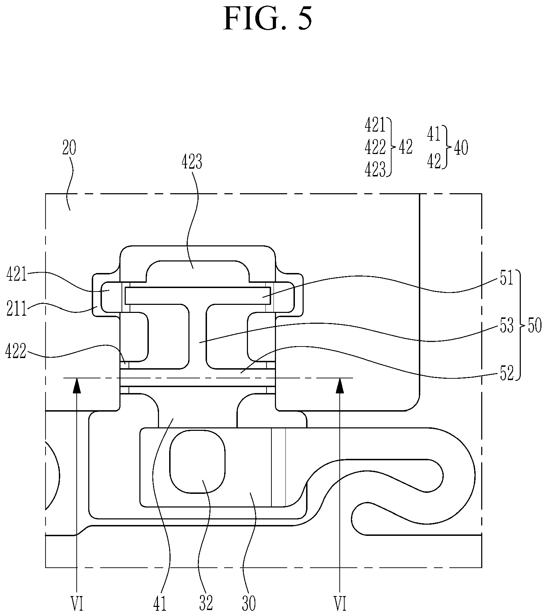

FIG. 5 is a top plan view showing the flexible printed circuit, the temperature sensing tab, elastic member and the busbar holder of FIG. 2. Referring to FIG. 5, for engagement of the first and second catching portions 421 and 422 and the busbar holder 20, the busbar holder 20 may be provided with a seating groove 211 and a hook 212. The seating groove 211 may be formed in a structure having an open top in the upper surface of the busbar holder 20, correspond to the first catching portion 421. Through this open structure, the first catching portion 421 may be seated in the seating groove 211.

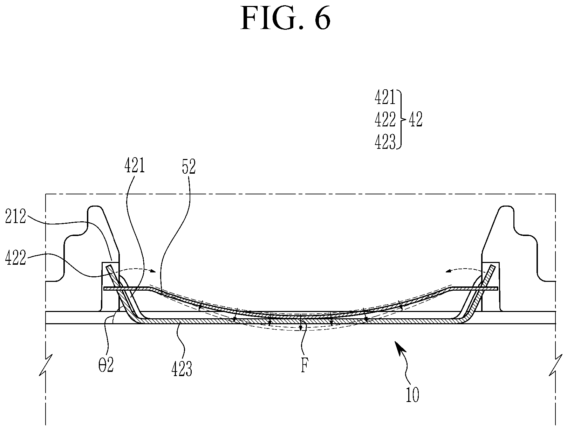

FIG. 6 is a cross-sectional view taken along the line VI-VI in FIG. 5. Referring to FIG. 6, the hook 212 may be arranged in an open bottom area of the lower surface of the busbar holder 20, corresponding to the second catching portion 422. Through this structure, the second catching portion 422 may be caught by the hook 212. Accordingly, the first and second catching portions 421 and 422 may be seated on and coupled to the seating groove 211 and the hook 212 in upper and lower surfaces of the busbar holder 20, respectively, .

In addition, the first catching portion 421 is formed in a horizontal state and disposed on the seating groove 211, and the second catching portion 422 is formed in an inclined state and caught under the hook 212. The pair of first catching portions 421 is caught by the seating groove 211 in the upper surface of the busbar holder 20, and the pair of second catching portions 422 is caught by the hook 212 in the lower surface of the busbar holder 20. Accordingly, the contact plate portion 423 may maintain a stable contact structure with respect to the battery cell 10.

Referring to FIG. 4 and FIG. 6, the second catching portion 422 may form a first angle θ1 in a free state, that may be a free state of the second catching portion 422, by being bent from the contact plate portion 423, and when it is caught by the hook 212, may form a second angle θ2 that is greater than the first angle θ1. For example, as the second catching portion 422 is gathered to (e.g., is pushed toward) the center by the hook 212, an outer angle between the second catching portion 422 and the battery cell 10 may be increased.

The second catching portion 422 may be spread under the hook 212 because the hook 212 is inserted from above, and the second angle, in the inserted state, may be smaller than the first angle in the free state.

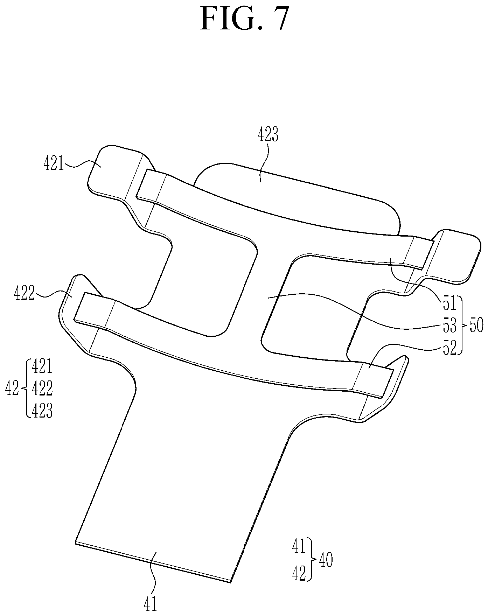

FIG. 7 is a perspective view of the temperature sensing tab shown in FIG. 3. Referring to FIG. 7 to FIG. 9, the second elastic portion 52 may be formed in a curved shape (e.g., in a curved line) convex toward the cell contact portion 42 in the free state and may provide an elastic force toward the cell contact portion 42 in a state in which it is coupled to the second catching portion 422 caught by the hook 212. The free state may be a free state of the second elastic portion 52.

Referring to FIG. 6, an elastic force F provided to the cell contact portion 42 through the second catching portion 422 by the second elastic portion 52 may be highest at a center of the cell contact portion 42 (e.g., the center of FIG. 6 in the left-and-right direction) and may decrease toward both ends.

Referring to FIG. 4, the first catching portion 421 may form the angle θ that is greater than the first angle θ1 in the free state by being bent from the contact plate portion 423. The free state may be a free state of the first catching portion 421. As shown in FIG. 9, in the state in which the second catching portion 422 is coupled to the hook 212, the second catching portion 422 may form the second angle θ2, and the second angle θ2 is similar to the angle θ in the state in which the first catching portion 421 is seated on the seating groove 211 (see, e.g., FIG. 9). For example, the first and second catching portions 421 and 422 may be parallel to each other in the inclined state.

The first elastic portion 51 may have a curved shape (e.g., may have a curved line shape) convex toward the contact plate portion 423 in the free state and may provide an elastic force toward the cell contact portion 42 in a state in which it is coupled to the first catching portion 421 disposed in the seating groove 211. The free state may be a free state oof the first elastic portion 51.

The elastic force provided to the cell contact portion 42 by the first catching portion 421, which receives the elastic force of the first elastic portion 51, may be highest at a center of the cell contact portion 42 (the center of FIG. 6 in the left-and-right direction) and may decrease toward both ends. This may be seen from the elastic force F of the second catching portion 422 by the second elastic portion 52 shown in, for example, FIG. 6.

Because the first and second elastic portions 51 and 52 of the elastic member 50 pressurize or press the first catching portion 421 and the second catching portion 422, respectively, such that the contact plate portion 423 may be elastically supported by and in contact with the battery cell 10, welding the contact plate portion 423 and the battery cell 10 is unnecessary. Accordingly, defects that may be caused by welding may be eliminated. In addition, costs, such as the process cost and quality management cost due welding, may be eliminated. While the present disclosure has been described in connection with what is presently considered to be practical embodiments, it is to be understood that the present disclosure is not limited to the disclosed embodiments but, on the contrary, is intended to cover various modifications included within the scope of the appended claims.

**Reference Numerals**

| | | | |
|---|---|---|---|
| 10: | battery cell | 20: | the busbar holder |
| 30: | flexible printed circuit (FPC) | 31: | temperature sensor |
| 32: | insulation material | 40: | the temperature sensing tab |
| 41: | sensor connection portion | 42: | cell contact portion |
| 50: | elastic member | 51: | first elastic portion |
| 52: | second elastic portion | 53: | connection portion |
| 211: | seating groove | 212: | hook |
| 421: | first catching portion | 422: | second catching portion |
| 423: | contact plate portion | F: | elastic force |
| G1: | first gap | G2: | second gap |
| H1: | 1 first through hole | H2: | second through hole |
| θ: | angle | θ1: | first angle |
| θ2: | second angle | | |

## Claims

1. A rechargeable battery module comprising:
a busbar holder (20) configured to cover a plurality of battery cells (10);
a flexible printed circuit (30), FPC, configured to transmit a signal corresponding to a detected temperature of at least one of the battery cells (10) from a temperature sensor (31) mounted on the busbar holder (20);
a temperature sensing tab (40) comprising a sensor connection portion (41) at a first side that is connected to the temperature sensor (31) and a cell contact portion (42) at a second side that is coupled to the busbar holder (20) and in contact with the at least one of the battery cells (10); and
an elastic member (50) coupled to the cell contact portion (42) and configured to elastically pressurize the cell contact portion (42) onto the at least one of the battery cells (10).

2. The rechargeable battery module of claim 1, wherein the cell contact portion (42) comprises:
a contact plate portion (423) in contact with the at least one of the battery cells (10);
a first catching portion (421) in the contact plate portion (423) at a side away from or opposite to the sensor connection portion (41) and on the busbar holder (20); and
a second catching portion (422) spaced apart from the first catching portion (421) and in the contact plate portion (423) nearer to the sensor connection portion (41) than the first catching portion (421) and coupled under the busbar holder (20).

3. The rechargeable battery module of claim 2, wherein the elastic member (50) comprises:
a first elastic portion (51) coupled at a first through hole in the first catching portion (421) and configured to apply an elastic force to the first catching portion (421); and
a second elastic portion (52) coupled at a second through hole in the second catching portion (422) and configured to apply an elastic force to the second catching portion (422).

4. The rechargeable battery module of claim 3, wherein the elastic member (50) further comprises a connection portion (53) interconnecting the first elastic portion (51) and the second elastic portion (52) in a crossing direction.

5. The rechargeable battery module of claim 2, wherein the busbar holder (20) comprises:
a seating groove (211) having an open top corresponding to the first catching portion (421); and
a hook (212) having an open bottom corresponding to the second catching portion (422).

6. The rechargeable battery module of claim 5, wherein the first catching portion (421) extends in a horizontal direction in the seating groove (211), and
wherein the second catching portion (422) extends in an inclined direction and is restrained under the hook (212).

7. The rechargeable battery module of claim 5 or 6, wherein the second catching portion (422) is configured to:
in a first state, form a first angle by being bent from the contact plate portion (423); and
in a second state when caught by the hook (212), form a second angle that is greater than the first angle.

8. The rechargeable battery module of claim 6 or 7, wherein a second elastic portion (52) of the elastic member (50) has a curved shape convex toward the contact plate portion (423) in its free state and is configured to provide an elastic force toward the contact plate portion (423) in a state in which it is coupled to the second catching portion (422) restrained by the hook (212).

9. The rechargeable battery module of claim 8, wherein the elastic force provided to the contact plate portion (423) through the second catching portion (422) by the second elastic portion (52) is highest at a center of the contact plate portion (423) and decreases toward both ends.

10. The rechargeable battery module of any of claims 7 to 9, wherein, in its free state, the first catching portion (421) is configured to form an angle that is greater than the first angle by being bent from the contact plate portion (423).

11. The rechargeable battery module of any of claims 7 to 10, wherein, in its free state, a first elastic portion (51) of the elastic member (50) has a curved shape convex toward the contact plate portion (423) and is configured to provide an elastic force toward the contact plate portion (423) in a state in which it is coupled to the first catching portion (421) in the seating groove (211).

12. The rechargeable battery module of claim 11, wherein the elastic force provided to the contact plate portion (423) through the first catching portion (421) by the first elastic portion (51) is highest at a center of the contact plate portion (423) and decreases toward both ends.

13. The rechargeable battery module of claim 1, wherein the cell contact portion (42) comprises:
a contact plate portion (423) in contact with the at least one of the battery cells (10);
a pair of first catching portions (421) respectively extending from opposite sides of the contact plate portion (423) in a width direction at an area of the contact plate portion (423) away from the sensor connection portion (41), the first catching portions (421) being on the busbar holder (20); and
a pair of second catching portions (422) respectively extending from the opposite sides of the contact plate portion (423) in the width direction at another area of the contact plate portion (423) nearer to the sensor connection portion (41), the second catching portions (422) being coupled under the busbar holder (20).

14. The rechargeable battery module of claim 13, wherein the elastic member (50) comprises:
a first elastic portion (51) coupled to each of first through holes respectively in the pair of first catching portions (421) and configured to apply an elastic force to the first catching portion (421); and
a second elastic portion (52) coupled to each of second through holes respectively in the pair of second catching portions (422) and configured to apply an elastic force to the second catching portion (422).

15. The rechargeable battery module of claim 13 or 14, wherein, at the same height on the contact plate portion (423):
the pair of first catching portions (421) form a first gap; and
the pair of second catching portions (422) form a second gap that is greater than the first gap.
